(19) Europäisches Patentamt
European Patent Office
Office européen des brevets

(11) **EP 3 159 681 B1**

(12) **EUROPÄISCHE PATENTSCHRIFT**

(45) Veröffentlichungstag und Bekanntmachung des Hinweises auf die Patenterteilung:
**27.11.2019 Patentblatt 2019/48**

(51) Int Cl.:
*G01N 24/08* (2006.01)　　*G01R 33/46* (2006.01)

(21) Anmeldenummer: **16193503.6**

(22) Anmeldetag: **12.10.2016**

(54) **VERFAHREN UND VORRICHTUNG ZUR AUTOMATISIERBAREN ERMITTLUNG DER BESTIMMUNGSGRENZE UND DES RELATIVEN FEHLERS BEI DER QUANTIFIZIERUNG DER KONZENTRATION EINER ZU UNTERSUCHENDEN SUBSTANZ IN EINER MESSPROBE**

METHOD AND DEVICE FOR AUTOMATABLE DETERMINATION OF THE DETECTION THRESHOLD AND THE RELATIVE ERROR IN THE QUANTIFICATION OF THE CONCENTRATION OF A SUBSTANCE TO BE TESTED IN A MEASURING PROBE

PROCÉDÉ ET DISPOSITIF DE DÉTERMINATION POUVANT ÊTRE AUTOMATISÉE DE LA LIMITE DE DÉTECTION ET DE L'ERREUR RELATIVE LORS DE LA QUANTIFICATION DE LA CONCENTRATION D'UNE SUBSTANCE À ANALYSER DANS UN ÉCHANTILLON

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **19.10.2015 DE 102015220322**

(43) Veröffentlichungstag der Anmeldung:
**26.04.2017 Patentblatt 2017/17**

(73) Patentinhaber: **Bruker BioSpin GmbH**
**76287 Rheinstetten (DE)**

(72) Erfinder:
• **Fischer, Christian**
**76287 Rheinstetten (DE)**
• **Kuhl, Carsten**
**76227 Karlsruhe (DE)**
• **Colson, Kimberly**
**Westford, MA Massachusetts 01886 (US)**

(74) Vertreter: **Kohler Schmid Möbus Patentanwälte Partnerschaftsgesellschaft mbB**
**Gropiusplatz 10**
**70563 Stuttgart (DE)**

(56) Entgegenhaltungen:
**DE-A1-102014 203 721**

• **SCHÖNBERGER T ET AL: "Guide to NMR Method Development and Validation - Part I: Identification and Quantification, Technical Report No. 01/2014", INTERNET CITATION, Mai 2014 (2014-05), Seiten 1-20, XP002751806, Gefunden im Internet: URL:http://www.eurolab.org/documents/EUROL AB%20Technical%20Report%20NMR%20Metho d%20D evelopment%20and%20Validation%20May%202 014 _final.pdf [gefunden am 2015-12-04]**
• **Armbruster Et Al.: "Limit of Blank, Limit of Detection and Limit of Quantitation", Online Clin Biochem Rev, 1. August 2008 (2008-08-01), XP055296896, Gefunden im Internet: URL:https://www.researchgate.net/profile/D avid_Armbruster/publication/23317899_Limit _of_blank_limit_of_detection_and_limit_of_ quantitation/links/543d1cc40cf2c432f7424da 5.pdf [gefunden am 2016-08-23]**
• **Aldo Marchetto ET AL: "Limit of Detection (LOD) and Limit of Quantification (LOQ) estimation and use in the chemical lab, Life+ FutMon -Working Group on QA/QC in Laboratories Meeting of the Heads of the Laboratories 12-13 October 2009 in Warsaw", , 12. Oktober 2009 (2009-10-12), XP055351993, Warsaw Gefunden im Internet: URL:http://www.idrolab.ise.cnr.it/images/d oc/lod_loq.pdf [gefunden am 2017-03-06]**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

• ALANKAR SHRIVASTAVA ET AL: "Methods for the determination of limit of detection and limit of quantitation of the analytical methods", CHRONICLES OF YOUNG SCIENTISTS, Bd. 2, Nr. 1, 1. Januar 2011 (2011-01-01), Seite 21, XP055351994, ISSN: 2229-5186, DOI: 10.4103/2229-5186.79345

**Beschreibung**

Die Erfindung betrifft ein spektroskopisches Verfahren zur Ermittlung der Bestimmungsgrenze (= "limit of quantification" LOQ) und zur Ermittlung des relativen Fehlers bei der Quantifizierung der Konzentration einer zu untersuchenden Substanz in einer Messprobe, wobei die Bestimmungsgrenze angibt, bei welcher Konzentration der Substanz der relative Fehler einen vorgegebenen Wert $E_B$ erreicht, und wobei in einem gemessenen Spektrum eine Intensität als Funktion einer Position mit einem Signalanteil bestimmt wird, welcher auf die Substanz zurückzuführen ist.

Ein derartiges spektroskopisches Verfahren ist etwa bekannt aus der DE 10 2014 203 721 A1 (=Referenz [2]).

Eine häufige Aufgabenstellung in der Qualitätssicherung in zahlreichen industriellen Prozessen, oder auch in Forschung und medizinischer Diagnostik, ist die quantitative Überprüfung der Zusammensetzung einer genommenen Probe, insbesondere die Bestimmung der Konzentration einer bestimmten Substanz in der Probe. Um die Konzentration einer Substanz in eine Probe zu bestimmen, kann die in der Probe enthaltene Substanz mit einem Reagenz quantitativ umgesetzt werden, etwa bis ein Farbumschlag eines zugesetzten Indikators das Ende der Umsetzungsreaktion anzeigt, wobei die Menge des zugesetzten Reagenz mitverfolgt wird. Solche konventionellen chemischen Verfahren sind jedoch recht aufwendig und wurden in letzter Zeit durch spektroskopische Methoden weitgehend ersetzt. Bei spektroskopischen Methoden wird die Wechselwirkung der Substanz in der Probe mit einer untersuchenden Strahlung genutzt, um die Konzentration zu bestimmen.

Eine leistungsfähige spektroskopische Methode der quantitativen analytischen Chemie ist die NMR(=Kernspinresonanz, nuclear magnetic resonance)-Spektroskopie. Typischerweise werden hierbei in der eindimensionalen NMR-Spektroskopie die in der Probe enthaltenen Kernspins in einem starken, statischen magnetischen Feld ausgerichtet, und mit einem Hochfrequenz-Puls wird die Kernmagnetisierung um 90° gedreht. Anschließend wird die Hochfrequenz-Antwort der Probe als Funktion der Zeit aufgezeichnet (FID-Signal, FID=free induction decay). Durch Fourier-Transformation kann aus dem Zeitsignal ein Frequenzspektrum der Probe erhalten werden, in welchem für die einzelnen Bestandteile der Probe charakteristische Peaks (Spitzen) enthalten sind, wobei die einzelnen Peaks der Bestandteile mehr oder weniger stark überlagern.

Die Intensität der Peaks der einzelnen Bestandteile der Probe ist grundsätzlich proportional zur Konzentration des zugehörigen Bestandteils in der Probe. Allerdings ist es aufgrund der Überlagerung einer Vielzahl von Peaks in einem Spektrum oft nicht einfach, den Signalanteil, der zu einer bestimmten Substanz gehört, quantitativ zu bestimmen. Dies gilt nicht nur für die NMR, sondern auch für andere spektroskopische Methoden wie IR(=Infrarot)-Spektroskopie oder Röntgen-Spektroskopie (Röntgenfluoreszenz oder Röntgenabsorption).

Es ist auch bekannt, in einem Referenzspektrum der zu bestimmenden Substanz die zur Substanz gehörenden einzelnen Peaks zu identifizieren und die relativen Positionen, Intensitäten, Linienbreiten und Linienformen zu ermitteln. Sodann kann ein Anfitten der Peaks an das gemessene Spektrum der Probe erfolgen, und unter den angefitteten Peaks kann wiederum zur Bestimmung des Signalanteils der Substanz integriert werden. Dieser so genannte Multiplet-Ansatz ist beispielsweise in der Spektralanalysesoftware "Chenomx NMR Suite" der Chenomx Inc., Edmonton, Alberta, CA, implementiert.

Ganz wesentlich für die Bewertung der Ergebnisse bei der Auswertung von Spektren ist die Bestimmungsgrenze und der Fehler der Quantifizierung bei der ermittelten Konzentration einer zu untersuchenden Substanz.

Die Bestimmungsgrenze (= "limit of quantification" LOQ) ist die kleinste Konzentration einer Substanz in einer Messprobe, die quantitativ mit einer festgelegten Präzision, z.B. dem relativen Fehler, bestimmt werden kann. Mess-Ergebnisse werden üblicherweise erst angegeben, wenn dieser Wert erreicht wird.

Die Detektionsgrenze oder Nachweisgrenze (= "limit of detection" LOD) ist die kleinste Konzentration einer Substanz in einer Messprobe, bei der die Substanz gerade noch zuverlässig nachgewiesen werden kann. Beispielsweise kann man die Detektionsgrenze ermitteln, indem man die Konzentration wählt, ab der die ermittelte Konzentration > 0 wird. Alle Werte unterhalb dieser Konzentration werden als "nicht detektierbar" bezeichnet.

Das Integral eines Signals einer Substanz ist im Allgemeinen direkt proportional zu der Konzentration. In der optischen Spektroskopie (IR, UV, visuell) wird dieser Sachverhalt durch das Lambert-Beer'sche Gesetz beschrieben, analog verhält es sich in der NMR Spektroskopie.

Aufgrund der Linearität von Signal und Konzentration ist es möglich, durch Addition von Spektren künstliche Mischungen herzustellen (siehe etwa Referenz [3]). Der Fachmann bezeichnet die Zugabe einer definierten Menge einer Substanz zu einer Mischung als "Spiking". Wird statt der realen Zugabe einer Substanz ein Spektrum der Substanz mit einem definierten Integral zu einem Spektrum einer Mischung addiert, spricht der Fachmann von "Electronic Spiking".

Die Quantifizierung einer Substanz in einem Spektrum kann auf verschiedene Weisen erfolgen:

    1. Integration einer Region durch Aufsummieren der Intensitätswerte

    2. Identifikation der Einzelsignale mit anschließendem Aufsummieren der einzelnen Integrale

    3. Anpassen einer Linienform ("Modell") an ein experimentelles Signal (siehe Referenz [2]).

Diese Verfahren sind dem Fachmann bekannt. Die obigen Verfahren 2 und 3 benutzen zur Anpassung der einzelnen Parameter iterative Algorithmen, z.B. Marquard Levenberg oder Gauss Newton. Intern wird zur Berechnung der Abweichung von Modell und Experiment in jedem Iterationsschritt üblicherweise die Methode der kleinsten Quadrate verwendet. Diese Methode hat sich in der Praxis bewährt. Außerdem wird aus praktischen Gründen (vor allem Rechenzeit) eine Toleranz angenommen: wenn sich die Werte bei der Iteration weniger als die vorgegebene Toleranz ändern, so wird die Berechnung abgebrochen. Beispielsweise wird die Iteration abgebrochen, wenn bei der Berechnung der Zielgenauigkeit die Änderung innerhalb der Toleranz liegt.

Die Quantifizierungen nach Verfahren 2 und 3 liefern genauere Ergebnisse aber benötigen viel Rechenzeit. Es ist daher wichtig, die Anzahl der notwendigen Schritte bei einer Quantifizierung möglichst stark zu begrenzen.

Die Genauigkeit des Quantifizierungsergebnisses ist von vielen Faktoren abhängig. Einer dieser Faktoren ist der spektrale Untergrund, der sich u.a. zusammensetzt aus:

- Rauschen
- Andere Signale in der Region die mit der Substanz überlappen.

Mit steigender Substanzkonzentration spielen diese Effekte eine immer geringere Rolle, da der relative Fehler kleiner wird.

Übliche Verfahren zur Bestimmung von LOQ, LOD (nach Referenz [1])

- Visuelle Definition
- Signal / Rausch Verhältnis: LOD: 2-3 * Rauschlevel, LOQ: 10 * Rauschlevel
- Standardabweichung in einem Spektrum einer Blank Probe nach Gleichung 1
- Berechnung anhand der Kalibrationslinie (z.B. lineare Regression) bei niedriger Konzentration nach folgender Gleichung:

$$LOD / LOQ = F * SD / b$$

F: Faktor, z.B. LOD F = 3.3 LOQ = 10.0. Akzeptierte Werte in der Praxis [1].
SD: Standardabweichung. Beispiele nach [1]:

- Punkte in der Rauschregion im Blank Spektrum.
- Residuen der linearen Regression der Kalibrationslinie

b: Steigung der Kalibrationslinie / Werte im Spektrum

Die vorliegende Erfindung geht aus von einen Stand der Technik gemäß einer Version in der Bruker Software "AssureNMR" (siehe Referenz [4]). Hier werden folgende Schritte zur LOQ Bestimmung durchgeführt:

1. Zuerst wird eine Quantifizierung bei der Konzentration 0, also den reinen Blank Spektren, durchgeführt. Wird die Substanz nicht identifiziert, wird der relative Fehler in diesem Fall auf "unendlich" gesetzt, da die erwartete Konzentration null ist.
2. Eine Start-Konzentration wird ermittelt. Aus praktischen Gründen wird die Konzentration "1" angenommen, unabhängig von der Einheit. Dann wird das Probenspektrum berechnet und anschließend quantifiziert. Falls die Quantifizierung nicht erfolgreich ist, wird die Konzentration so lange mit dem Faktor 10 multipliziert, bis eine Konzentration > 0 und ein Fehler kleiner dem angestrebten relativen Fehler ermittelt ist.
3. Iteration nach der Methode Binäre Suche:

   a. Ermittlung der aktuellen Konzentration = Mittelwert aus größter Konzentration > max. relativer Fehler und kleinster Konzentration < max. relativer Fehler.
   b. Elektronic spiking + Quantifizierung
   c. Bestimmung des relativen Fehlers
   d. Distanz zwischen größter Konzentration > max. relativer Fehler und kleinster Konzentration < max. relativer Fehler
   e. Ist diese Distanz kleiner als die geforderte Genauigkeit? Dann Abbruch.

4. LOQ ist die kleinste Konzentration < max. relativer Fehler innerhalb der erlaubten Toleranz.

Die Anzahl der Iterationen kann sehr groß werden, es wird gewissermaßen blind gesucht. Das Verfahren benötigt eine große Anzahl von Iterationsschritten und ist durch die vielen durchzuführenden Quantifizierungsschritte relativ langsam.

Außerdem gibt es bisher keine Möglichkeit die Genauigkeit von Quantifizierungsergebnissen bei aktuell ermittelter Konzentration abzuschätzen. Die Abschätzung der Genauigkeit in Abhängigkeit von der Konzentration wurde bisher nicht gemacht.

Die bekannten Verfahren und herkömmlichen Lösungen können nach dem Stand der Technik daher zumindest folgende Nachteile bzw. Mängel auf weisen:

- Keine Bestimmung des Fehlers bei gegebener Konzentration möglich
- Manuelles Erstellen von Konzentrationsreihen (elektronisch und chemisch)
- Einfache Formel: Signal / Rausch Verhältnis multipliziert mit einem Faktor berücksichtigt nicht chemischen Untergrund: Signale in der Region durch andere Substanzen, evtl. in niedriger Konzentration.

- Bestimmung von LOQ bei verschiedenen vorgegebenen Genauigkeitswerten $E_B$ durch einmalige Berechnung der Modellfunktion. In der Praxis werden häufig zwei Bestimmungsgrenzen angegeben, beispielsweise 1% und 5%.

## Aufgabe der Erfindung

Der vorliegenden Erfindung liegt demgegenüber die -im Detail betrachtet relativ anspruchsvolle und komplexe- Aufgabe zugrunde, ein vereinfachtes, automatisierbares Verfahren für die Ermittlung der Bestimmungsgrenze sowie die Möglichkeit zur quantitativen Abschätzung des Fehlers einer ermittelten Konzentration einer Substanz in einer Probe unter Berücksichtigung des chemischen Untergrunds bereitzustellen.

## Kurze Beschreibung der Erfindung

Diese Aufgabe wird durch die vorliegende Erfindung auf ebenso überraschend einfache -für den Fachmann leicht durchzuführende- wie wirkungsvolle Weise gelöst durch ein gattungsgemäßes Verfahren der eingangs definierten Art mit folgenden Schritten beziehungsweise Schrittfolgen:

- 1. Auswählen einer Fehlerfunktion F(C), die angibt, wie sich der relative Messfehler mit der Konzentration C der Substanz ändert und von n Parametern abhängig ist;
- 2. Hinterlegen eines Blank-Spektrums;
- 3. Erfassen eines Referenz-Spektrums mit dem Signalanteil der zu untersuchenden Substanz;
- 4. Festlegen von Start-Konzentrationen $C_i^0$ (i=1..n) der Substanz in mindestens der Anzahl n;
- 5. Durchführung von folgenden Einzelschritten für jede Start-Konzentration $C_i^0$ (i=1...n);

  a) Multiplikation des Referenz-Spektrums mit demjenigen Signalanteil der Substanz mit einem Faktor, welcher so gewählt ist, dass der Signalanteil der Konzentration der Substanz entspricht;
  b) Addieren des Spektrums aus Einzelschritt 5a) zu dem Blank-Spektrum aus Verfahrensschritt 2. und Bestimmung der Konzentration der Substanz $C_i^{step}$ sowie Ermittlung des zugehörigen relativen Fehlers $E_i^{step}$;

- 6. iterative Anpassung der Parameter der gewählten Fehlerfunktion F(C) durch folgende Zwischenschritte:

  a) Bestimmung der n Parameter der Fehlerfunktion mit Hilfe der bisher ermittelten relativen Fehler $E_i^{step}$ aus Einzelschritt 5b) zu jeder entsprechenden Konzentration $C_i^{step}$;

  b) Bestimmung eines neuen Konzentrationswerts $C_x$, wobei die Fehlerfunktion mit den in Zwischenschritt 6a) bestimmten Parametern benutzt wird, um die Konzentration bei dem vorgegebenen Wert des Fehlers $E_B$ zu ermitteln;
  c) Durchführung von folgenden Einzelschritten für die in Schritt 6b) ermittelte Konzentration $C_x$:

    i) Multiplikation des Referenz-Spektrums mit dem Signalanteil der Substanz mit einem Faktor, der so gewählt ist, dass der Signalanteil der Konzentration $C_x$ der Substanz entspricht;
    ii) Addieren des Spektrums aus Einzelschritt i) zu dem Blank-Spektrum aus Verfahrensschritt 2. und Bestimmung der Konzentration der Substanz $C_x^{step}$ sowie Ermittlung des relativen Fehlers $E_x^{step}$;

  d) Wiederholung der Zwischenschritte 6a) bis c) mit den aus den Startkonzentrationen $C_i^0$ ermittelten Werten für die Konzentration $C_i^{step}$ und den relativen Fehler $E_i^{step}$ und zusätzlich den ermittelten Werten für die Konzentration der Substanz $C_x^{step}$ und den relativen Fehler $E_x^{step}$ solange bis für den ermittelten Wert der Konzentration $C_x^{step}$ der ermittelte Wert des relativen Fehlers innerhalb eines geforderten Toleranzbereiches der vorgegebenen Bestimmungsgrenze $E_B$ liegt,

- 7. Aufnahme eines Mess-Spektrums der Messprobe und Bestimmung der Konzentration C der zu untersuchenden Substanz mit demselben Verfahren wie in Einzelschritt 5b) und Abgleich mit der ermittelten Bestimmungsgrenze sowie Berechnung des relativen Fehleranteils durch Anwendung der Fehlerfunktion aus Verfahrensschritt 6.

Die Fehlerfunktion beschreibt dabei den Fehler im Abhängigkeit von der Konzentration. Konzentrationen sind entweder 0 oder positiv. Bei sehr kleinen Konzentrationen geht der Fehler gegen unendlich, insbesondere wenn die Substanz nicht detektiert wird und damit die ermittelte Konzentration 0 ist. Die Funktion fällt daher am Anfang steil ab, wird dann flacher. Da mit zunehmender Konzentration der relative Fehler immer kleiner wird, handelt es sich um eine monoton fallende Funktion. Exponentialfunktionen erfüllen diese Bedingungen und haben sich beim Testen als geeignet herausgestellt.

Die Konzentration ergibt sich aus der Signalintensität des Peaks bei der gegebenen Hardware. Die Konzentrationen werden in einem erwarteten Bereich gewählt. Im Ausführungsbeispiel geht man von einem Wert (z.B. 1mmol) aus, wenn der nicht sinnvoll ist, multipliziert man so lange um einen Faktor 10 bis ein sinnvoller Wert erhalten wird. Dann nimmt man daraus die Hälfte, usw.

Schritt 5b) ist zwar *per se* aus dem Stand der Technik bekannt, aber dennoch im vorliegenden Kontext nicht trivial und erfordert die hauptsächliche Rechnerleistung. Die gesuchten Signale werden in das Spektrum bei gegebener Konzentration eingepasst. Für den anschließenden Teil des Verfahrensschritt 5b) "Bestimmung der Konzentration $C_{step}$" gibt es verschiedene Möglichkeiten das Reinspektrum an das Gemischspektrum zu fitten.

Etwas anspruchsvoller ist der Verfahrensschritt 6a) "Bestimmung der n Parameter der Fehlerfunktion". Dieser Schritt umfasst eine mathematische Methode, um die Konzentration-Fehlerkurve anzupassen, wobei hier ein Verfahren mittels der kleinsten Fehlerquadrate bevorzugt wird. Aber auch in Schritt 6a) führen verschiedene Wege zu Ziel.

Gegebenenfalls können in einem Schritt 8 weitere Konzentrationswerte ermittelt werden, um die Modellfunktion besser anzupassen. Damit wird der Fehler der Modellfunktion minimiert.

Günstig kann in der Praxis auch ein Schritt 9 sein:

Messen und Quantifizieren eines oder mehrerer neuer Spektren durch folgende weiteren Iterationsschritte:

a) Aufnahme eines weiterer Mess-Spektren von der zu untersuchenden Messprobe, welche auch die gesuchte Mess-Substanz enthält;
b) Quantifizierung wie in Schritt 5b);
c) Berechnung eines relativen Fehleranteils des spektralen Untergrunds durch Anwendung der Modellfunktion.

Mit Hilfe der vorliegenden Erfindung werden nunmehr ermöglicht:

a) eine Ermittlung der Bestimmungsgrenze(bzw. Nachweisgrenze) bei der Quantifizierung einer Substanz in einer Probe;
b) eine Abschätzung des Fehlers durch den spektralen Untergrund (Signal / Rauschen) bei einer ermittelten Konzentration;
c) eine Ermittlung der Bestimmungsgrenze bei der statistischen Analyse einer Probe mit Antworten auf die Fragen "Ab welcher Konzentration der Substanz wird die Probe aus Ausreißer klassifiziert?" oder "In welchem Konzentrationsbereich wird die Probe als "im Modell" klassifiziert?".

Die Grundidee der oben beschriebenen erfindungsgemäßen Lösung ermöglicht die Erzielung erheblicher Vorteile:

a) Die Abhängigkeit des relativen Fehlers von der Konzentration wird als mathematische Funktion (Modellfunktion) bestimmt. Dadurch ist es möglich LOQ Werte bei verschiedenen Genauigkeiten (z.B. 1% Fehler, 5% Fehler) zu berechnen. Dieses Modell wird durch Simulationen (elektronisches Spiking) bestimmt. Fortwährendes Bestimmen der mathematischen Funktion während der Bestimmung eines vorgegebenen LOQ Wertes erlaubt es die Anzahl der Simulationen zu minimieren.

b) Ermittlung des Fehleranteils durch den spektralen Untergrund durch Anwenden der Modellfunktion bei der aktuell ermittelten Konzentration.

## Bevorzugte Varianten/Ausführungsformen der Erfindung

Da der relative Fehler mit steigender Konzentration kleiner wird, muss es sich bei der Funktion in der Regel um eine monoton fallende Funktion handeln. Exponentialfunktionen erfüllen diese Bedingungen und haben sich beim Testen als geeignet herausgestellt. Meist reicht ein exponential-Term (f(x) = a * exp(b*x) + c) in der Funktion, also eine Fehlerfunktion F(C)=a*exp(b*C)+d, wobei C die Konzentration und F(C) den relativen Fehler wiedergibt.

Noch genauere Ergebnisse konnten mit zwei Exponentialtermen (f(x) = a * exp(b*x) + c * exp(d*x) + e) erzielt werden.

Bei bevorzugten Verfahrensvarianten wird als Blank-Spektrum in Verfahrensschritt 2. ein Spektrum von einer Blank-Probe hinterlegt, welche die Substanz nicht enthält, oder ein theoretisches Rausch-Spektrum oder ein Spektrum von einer zu untersuchenden Messprobe, welche auch die gesuchte Mess-Substanz enthält, wobei die Konzentration der Substanz in der Messprobe bereits bekannt ist und die ermittelten Signale der Substanz von dem Spektrum abgezogen werden.

Bei der Verwendung mehrerer Blank-Proben können die Blank-Spektren im Vorfeld klassifiziert werden, wobei jeweils eine Fehlerfunktion pro Klasse bestimmt wird, um eine klassenspezifische Verarbeitung neuer Proben zu ermöglichen.

Das gemessene Spektrum kann vor dem Beginn des Optimierungsalgorithmus vorprozessiert werden, insbesondere durch Basislinien-Korrektur oder Phasenkorrektur. Ebenso kann das gemessene Referenzspektrum vor Beginn des Optimierungsalgorithmus vorprozessiert werden, insbesondere um schmale Spektrallinien (Peaks) zu erhalten.

Besonders bevorzugt ist eine Verfahrensvariante, bei der das Verfahren in der NMR(=Kernspinresonanz)-Spektroskopie, insbesondere der eindimensionalen NMR-Spektroskopie angewendet wird. Das gemessene Spektrum wird dabei aus einem FID-Signal der Probe durch Fouriertransformation gewonnen. Die Positionsangabe im Spektrum ist dann eine Frequenz, meist angegeben in ppm einer chemischen Verschiebung.

Ebenso ist eine Verfahrensvariante möglich, bei der das Verfahren in der optischen Spektroskopie, insbesondere der IR(=Infrarot)-Spektroskopie, oder der Röntgenspektroskopie oder der Massenspektroskopie angewandt wird. Die Positionsangabe wird dann in der Regel eine Wellenlänge sein. Auch hier können die einfachen Schritte des Verfahrens ohne einen Experten für spektrale Analysen leicht angewandt werden. Weiterhin ist eine Verfahrensvariante vorteilhaft, bei der die Probe eine flüssige Probe oder eine feste Probe, insbesondere eine pulverförmige Probe, ist. Bei flüssigen Proben treten starke Linienverbreiterungen insbesondere in der NMR auf, die durch das erfindungsgemäße Verfahren gut gehandhabt werden können. Die Erfindung ist aber auch bei festen Proben gut anwendbar.

Man beachte, dass auch mehrdimensionale Variablen im Rahmen der Erfindung in Betracht kommen (etwa in der so genannten 2-dimensionalen NMR-Spektroskopie).

In den Rahmen der vorliegenden Erfindung fällt auch eine Spektroskopie-Apparatur, eingerichtet zur automatischen Durchführung des erfindungsgemäßen Verfahrens, insbesondere wobei die Spektroskopie-Apparatur eine Messeinheit zur Aufnahme des gemessenen Spektrums der Probe und/oder des gemessenen Referenzspektrums der Substanz umfasst. Das erfindungsgemäße Verfahren ist besonders gut dazu geeignet, automatisch eingerichtet zu werden. Dazu können übliche Computersysteme mit entsprechender Programmierung und geeigneten Schnittstellen eingerichtet werden. Der Eingriff von Experten für spektroskopische Analyse ist grundsätzlich nicht notwendig, auch nicht für die Auswertung eines Referenzspektrums. Insofern ist es auch möglich, durch den Anwender neue Referenzspektren vermessen zu lassen und im erfindungsgemäßen Verfahren sogleich einzusetzen. Bevorzugt ist dafür die Spektroskopie-Apparatur nicht nur für die Datenauswertung, sondern auch für die Datenaufnahme eingerichtet.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Detaillierte Beschreibung der Erfindung und der Zeichnung

Die Erfindung ist in der Zeichnung dargestellt und wird anhand von Ausführungsbeispielen näher erläutert. Es zeigen:

Fig. 1    electronic Spiking von Alanin in Energy-Drink Spektren:
Alanin hat zwei Signale bei 1.50 ppm
unten: Spektrum ohne Alanin
Mitte und oben Spektren mit Alanin in verschiedenen Konzentrationen;

Fig. 2a    relativer Fehler als Funktion der Konzentration im ersten Iterationsschritt; und

Fig. 2b    relativer Fehler als Funktion der Konzentration im zweiten Iterationsschritt.

**Anwendungsbeispiel**

Aufgabenstellung: Quantifizierung von Alanin in Energy-Drinks
Messmethode: NMR Spektroskopie
Fragestellung: "Ab welcher Konzentration ist der ermittelte Wert genau genug?"
Ziel: Bestimmung des LOQ bei einem relativen Fehler von $E_B = 5\%$

Maximale Differenz zur Zielgenauigkeit (Toleranzbereich): 0.01 %

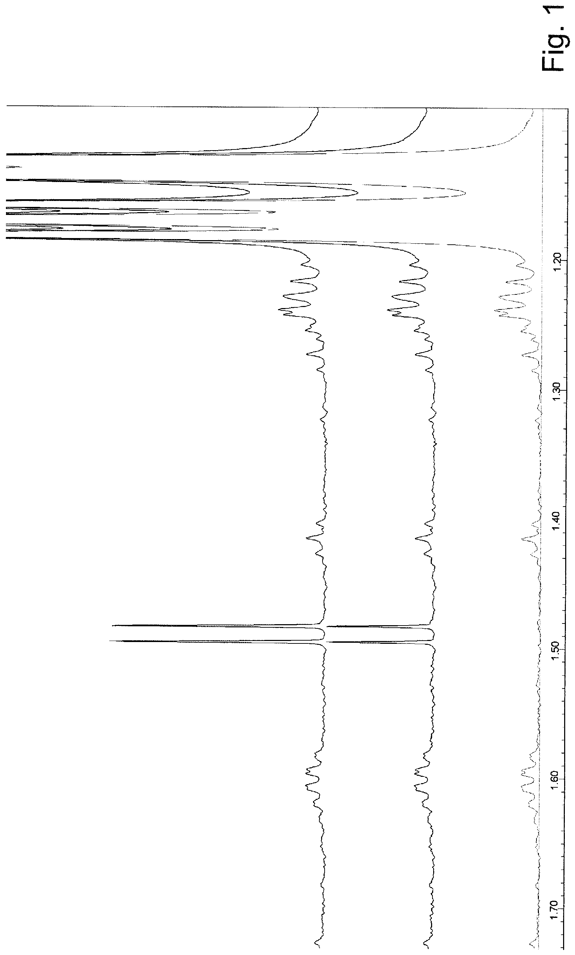

Fig.1 zeigt drei verschiedene, untereinander angeordnete Spektren mit Electronic Spiking von Alanin in einem Energy-Drink.

Alanin hat zwei Signale Teilspektren. Da der Bereich um 4 ppm stark überlagert ist, wird die Region um 1.5ppm verwendet.
Unten: ohne Alanin
Mitte und oben: Alanin in unterschiedlichen Konzentrationen.

**Herkömmliches Verfahren nach dem Stand der Technik in der Software AssureNMR** (siehe Referenz [4]):

Zuerst wird das reine Blank Spektrum verwendet. Dort wird das Signal von Alanin nicht detektiert. Im nächsten Schritt wird die Konzentration 1 mmol/l angenommen. Nun wird ein "Electronic Spiking" durchgeführt:

1. Es wird ein gemessenes Alanin Spektrum mit einem Faktor multipliziert, so dass sich für dieses eine Konzentration von 1 mmol/l ergibt.

2. Dieses Alanin Spektrum wird zum Blank Spektrum addiert.

Dieses künstliche Spektrum wird benutzt um Alanin zu quantifizieren. Erwartet wurde 1 mmol/l, ermittelt wurde 1.051197. Der relative Fehler beträgt 5.1197 % und ist damit größer als 5%.

Um auf eine Konzentration mit einem Fehler < 5% zu kommen wird der letzte Wert mit einem positiven Faktor multipliziert, in diesem Fall mit 10. Auch für diese Konzentration wird ein "Electronic Spiking" Spektrum erzeugt und anschließend eine Quantifizierung durchgeführt. Der relative Fehler beträgt hier 4.3499 % und ist kleiner als die Zielgenauigkeit.

Im nächsten Schritt beginnt die binäre Suche: die neue Konzentration wird ermittelt als Mittelwert aus kleinste Konzentration < 5% Fehler (10 mmol/l) und größter Konzentration > 5% Fehler (1 mmol/l). Damit ergibt sich in diesem Schritt eine Konzentration von 5.5 mmol/l. Die Anwendung von Electronic Spiking und Quantifizierung ergibt einen relativen Fehler von 4.4444 %.

Die Iteration wird weiter durchgeführt, die Tabelle unten gibt die Ergebnisse der weiteren Schritte an.

| Konzentration | Rel. Fehler |
|---|---|
| 0.0 | < Nachweisgrenze |
| 1.0 | 5.11967915767173 |
| 10.0 | 4.349932405998693 |
| 5.5 | 4.444416288701125 |
| 3.25 | 4.493444332420989 |
| 2.125 | 4.653167885874677 |
| 1.5625 | 4.819343640982979 |
| 1.28125 | 4.956825968990447 |
| 1.140625 | 5.045404570934175 |
| 1.2109375 | 5.000305382343138 |

LOQ wird ermittelt als 1.21 mmol/l, dort ist der relative Fehler mit 5.0003% kleiner als die angestrebte Toleranz. Insgesamt waren 10 Schritte erforderlich.

## Erfindungsgemäßes Verfahren

Da der relative Fehler mit zunehmender Konzentration kleiner wird, muss die Modelfunktion monoton fallend sein. Konzentrationen bewegen sich im Bereich der positiven reellen Zahlen inklusive 0. Bei der Konzentration 0 ist der relative Fehler unendlich. Exponentialfunktionen erfüllen diese Anforderungen.

In diesem Beispiel wird als Modelfunktion eine Exponentialfunktion gewählt:

$$F(c) = a * e^{(b*c)} + d$$

Diese Funktion liefert in der Praxis meistens ausreichend gute Werte. Eine alternative Funktion ist beispielsweise $F(c) = a * e^{(b*c)} + d * e^{(e*c)} + f$. Diese Funktion liefert etwas genauere Ergebnisse, benötigt durch ihre fünf Parameter aber erheblich längere Rechenzeiten.

Die gewählte Modelfunktion besitzt 3 Parameter, die angepasst werden müssen, wodurch zur ersten Iteration 3 Startkonzentrationen mit dazugehörigen relativen Fehlern benötigt werden. Startkonzentrationen werden aus dem erwarteten Konzentrationsbereich genommen, wobei eine sehr klein gewählt wird um die Funktion schneller anpassen zu können. In der Praxis hat sich ein Wert von 1 mmol/l als günstig erwiesen. Falls die Substanz bei diesem Wert nicht detektiert wird, so wird die Konzentration so lange mit einem Faktor von 10 multipliziert bis die Substanz detektiert wird. Der Wert wird dann beispielsweise so lange halbiert bis man die notwendige Anzahl von Startparametern ermittelt hat.

In diesem Beispiel werden die Werte 1, 5.5 und 10 mmol/l verwendet, analog zu dem Beispiel oben um eine Vergleichbarkeit der Verfahren zu gewährleisten.

Benutzt man diese Werte (siehe Tabelle oben) um die Modellfunktion an die Werte iterativ mit einem Marquard-Levenberg Algorithmus mittels des Prinzips der minimalen quadratischen Abweichung anzupassen, so ergeben sich als Parameter:
a = 1.215; b = -0.437; d = 4.335

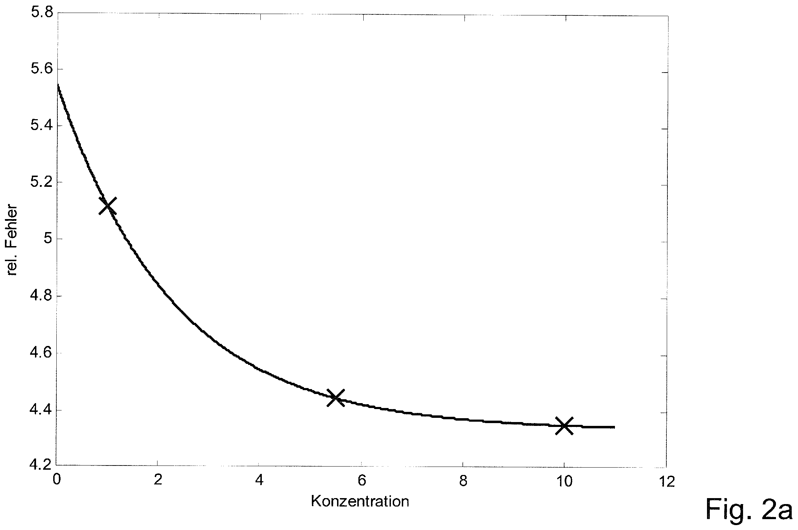

Fig. 2a zeigt das Ergebnis dieses ersten Iterationsschritts.

Um die neue Zielkonzentration zu ermitteln, wird die Modellfunktion umgeformt:

$$c = \ln((F(c)-d) / a) / b$$

wobei als F(c) der erwartete Fehler von $E_B$ = 5% eingesetzt wird.

Damit erhält man eine neue Konzentration von 1.3792 mmol/l, 4.89 % relativer Fehler.

Eine weitere Iteration nun mit 4 Wertepaaren ergibt
a = 1.605; b = -0.7958 ; d = 4.384

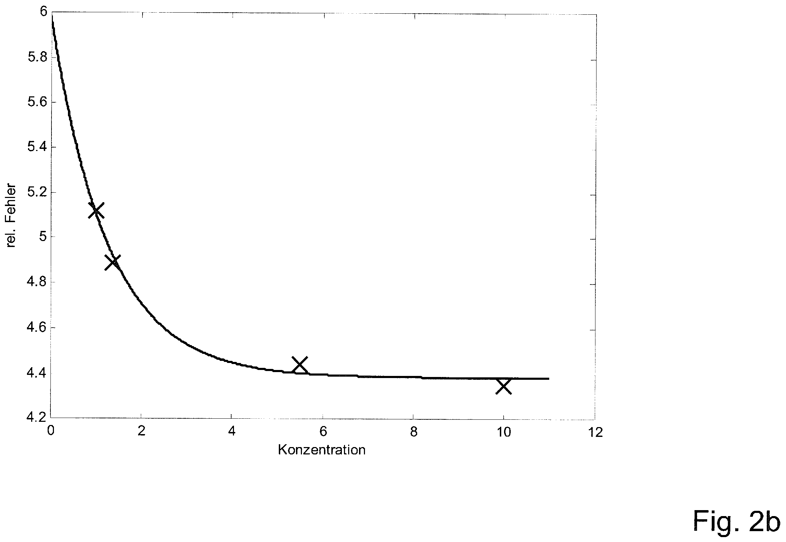

Fig. 2b zeigt nun das Ergebnis des zweiten Iterationsschritts.

Damit ergibt sich eine neue Konzentration von 1.2034 mmol/l.

Ein "Elektronic Spiking" und anschließende Quantifizierung ergibt einen relativen Fehler von 5.0048%, womit der Wert innerhalb der geforderten Toleranz von 0.01% liegt.

Mit dem Verfahren aus dem Stand der Technik muss man 10 Quantifizierungen ausführen, mit dem erfindungsgemäßen Verfahren lediglich 5.

Als weiterer Vorteil ergibt sich, dass man durch Anwendung der ermittelten Fehlerfunktion bei einer gegebenen Messung nun den relativen Fehler bei der aktuellen Konzentration konkret vorhersagen kann.

Referenzen

[1] Ermer, Joachim; Miller, John (Editor), Method Validation in Pharmaceutical Analysis, Wiley-VCH, Weinheim, 2005

[2] DE 10 2014 203 721 A1

[3] Munecy, H. et.al, MetAssimulo: Simulation of Realistic NMR Metabolic Profiles, BMC Bioinformatics 2010, 11:496 doi:10.1186/1471-2105-11-496

[4] Bruker Software "AssureNMR", publiziert auf der Internet-Seite https://www.bruker.com/fileadmin/user upload/8-PDF-Docs/MagneticResonance/Events NMR/ENC2015/Posters/17 ENC15 Assure-lores.pdf

## Patentansprüche

1. Spektroskopisches Verfahren zur Ermittlung der Bestimmungsgrenze (= "limit of quantification" LOQ) und zur Ermittlung des relativen Fehlers bei der Quantifizierung der Konzentration einer zu untersuchenden Substanz in einer Messprobe, wobei die Bestimmungsgrenze angibt, bei welcher Konzentration der Substanz der relative Fehler einen vorgegebenen Wert $E_B$ erreicht, und wobei in einem gemessenen Spektrum eine Intensität als Funktion einer Position mit einem Signalanteil bestimmt wird, welcher auf die Substanz zurückzuführen ist, mit folgenden Schritten beziehungsweise Schrittfolgen:

     - 1. Auswählen einer Fehlerfunktion F(C), die angibt, wie sich der relative Messfehler mit der Konzentration C der Substanz ändert und von n Parametern abhängig ist;
     - 2. Hinterlegen eines Blank-Spektrums;
     - 3. Erfassen eines Referenz-Spektrums mit dem Signalanteil der zu untersuchenden Substanz;
     - 4. Festlegen von Start-Konzentrationen $C_i^0$ (i=1..n) der Substanz in mindestens der Anzahl n;
     - 5. Durchführung von folgenden Einzelschritten für jede Start-Konzentration $C_i^0$ (i=1...n):

         a) Multiplikation des Referenz-Spektrums mit demjenigen Signalanteil der Substanz mit einem Faktor, welcher so gewählt ist, dass der Signalanteil der Konzentration der Substanz entspricht;
         b) Addieren des Spektrums aus Einzelschritt 5a) zu dem Blank-Spektrum aus Verfahrensschritt 2. und Bestimmung der Konzentration der Substanz $C_i^{step}$ sowie Ermittlung des zugehörigen relativen Fehlers $E_i^{step}$;

     - 6. iterative Anpassung der Parameter der gewählten Fehlerfunktion F(C) durch folgende Zwischenschritte:

         a) Bestimmung der n Parameter der Fehlerfunktion mit Hilfe der bisher ermittelten relativen Fehler $E_i^{step}$ aus Einzelschritt 5b) zu jeder entsprechenden Konzentration $C_i^{step}$;
         b) Bestimmung eines neuen Konzentrationswerts $C_x$, wobei die Fehlerfunktion mit den in Zwischenschritt 6a) bestimmten Parametern benutzt wird, um die Konzentration bei dem vorgegebenen Wert des Fehlers $E_B$ zu ermitteln;
         c) Durchführung _von folgenden Einzelschritten für die in Schritt 6b) ermittelte Konzentration $C_x$:

             i) Multiplikation des Referenz-Spektrums mit dem Signalanteil der Substanz mit einem Faktor, der so gewählt ist, dass der Signalanteil der Konzentration $C_x$ der Substanz entspricht;
             ii) Addieren des Spektrums aus Einzelschritt i) zu dem Blank-Spektrum aus Verfahrensschritt 2. und Bestimmung der Konzentration der Substanz $C_x^{step}$ sowie Ermittlung des relativen Fehlers $E_x^{step}$;

         d) Wiederholung der Zwischenschritte 6a) bis 6c) mit den aus den Startkonzentrationen $C_i^0$ ermittelten Werten für die Konzentration $C_i^{step}$ und den relativen Fehler $E_i^{step}$ und zusätzlich den ermittelten Werten für die Konzentration der Substanz $C_x^{step}$ und den relativen Fehler $E_x^{step}$ solange bis für den ermittelten Wert der Konzentration $C_x^{step}$ der ermittelte Wert des relativen Fehlers innerhalb eines geforderten Toleranzbereiches der vorgegebenen Bestimmungsgrenze $E_B$ liegt,

     - 7. Aufnahme eines Mess-Spektrums der Messprobe und Bestimmung der Konzentration C der zu untersuchenden Substanz mit demselben Verfahren wie in Einzelschritt 5b) und Abgleich mit der ermittelten Bestimmungsgrenze sowie Berechnung des relativen Fehleranteils durch Anwendung der Fehlerfunktion aus Verfahrensschritt 6.

2. Verfahren nach Anspruch 1, **dadurch gekennzeichnet, dass** als Fehlerfunktion F(C)=a*exp(b*C)+d gewählt wird, wobei C die Konzentration und F(C) den relativen Fehler wiedergibt.

3. Verfahren nach einem der vorhergehenden Ansprüche, **dadurch gekennzeichnet, dass** als Blank-Spektrum in Verfahrensschritt 2. ein Spektrum von einer Blank-Probe hinterlegt wird, welche die Substanz nicht enthält, oder dass als Blank-Spektrum in Verfahrensschritt 2. ein theoretisches Rausch-Spektrum oder ein Spektrum von einer zu untersuchenden Messprobe hinterlegt wird, welche auch die gesuchte Mess-Substanz enthält, wobei die Konzentration der Substanz in der Messprobe bereits bekannt ist und ermittelte Signale der Substanz von dem Spektrum abgezogen werden.

**4.** Verfahren nach einem der vorhergehenden Ansprüche, **dadurch gekennzeichnet, dass** bei der Verwendung mehrerer Blank-Proben die Blank-Spektren im Vorfeld klassifiziert werden und jeweils eine Fehlerfunktion pro Klasse bestimmt wird, um eine klassenspezifische Verarbeitung neuer Proben zu ermöglichen.

**5.** Spektroskopie-Apparatur, eingerichtet zur automatischen Durchführung eines Verfahrens nach einem der vorhergehenden Ansprüche, **dadurch gekennzeichnet, dass** die Spektroskopie-Apparatur eine Messeinheit zur Aufnahme des Mess-Spektrums der Messprobe und/oder eines gemessenen Referenz-Spektrums der zu untersuchenden Substanz umfasst.

**Claims**

**1.** A spectroscopic method for detecting the limit of quantification (LOQ) and for detecting the relative error when quantifying the concentration of a substance to be investigated in a test sample, wherein the limit of quantification specifies the concentration of the substance at which the relative error reaches a specified value $E_B$, and wherein, in a measured spectrum, an intensity is determined as a function of a position with a signal component which can be ascribed to the substance, comprising the following steps or sequences of steps:

- 1. Selection of an error function F(C) which specifies how the relative measuring error changes with the concentration C of the substance and is dependent on n parameters;
- 2. Provision of a blank spectrum;
- 3. Recording of a reference spectrum with the signal component of the substance to be investigated;
- 4. Determination of start concentrations $C_i^0$ (i=1..n) of the substance in at least the number n;
- 5. Carrying out the following individual steps for each start concentration $C_i^0$ (i=1 ...n):

a) Multiplication of the reference spectrum with that signal component of the substance by a factor which is chosen such that the signal component corresponds to the concentration of the substance;
b) Addition of the spectrum from individual step 5a) to the blank spectrum from method step 2. and determination of the concentration of the substance $C_i^{step}$ and detection of the associated relative error $E_i^{step}$;

- 6. Iterative adaptation of the parameters of the selected error function F(C) by means of the following intermediate steps:

a) Determination of the n parameters of the error function with the help of the previously determined relative errors $E_i^{step}$ from individual step 5b) for each corresponding concentration $C_i^{step}$;
b) Determination of a new concentration value $C_x$, wherein the error function with the parameters determined in intermediate step 6a) is used to detect the concentration at the specified value of the error $E_B$;
c) Carrying out the following individual steps for the concentration $C_x$ detected in step 6b):

i) multiplication of the reference spectrum with the signal component of the substance with a factor that is selected such that the signal component corresponds to the concentration $C_x$ of the substance;
ii) adding the spectrum from individual step i) to the blank spectrum from method step 2. and determination of the concentration of the substance $C_x^{step}$ as well as detection of the relative error $E_x^{step}$;

d) Repetition of the intermediate steps 6a) to 6c) with the values detected from the start concentrations $C_i^0$ for the concentration $C_i^{step}$ and the relative error $E_i^{step}$ and additionally the detected values for the concentration of the substance $C_x^{step}$ and the relative error $E_x^{step}$ for as long as the detected value of the relative error for the detected value of the concentration $C_x^{step}$ is within a required tolerance range of the specified limit of quantification $E_B$,

- 7. Recording of a measurement spectrum of the test sample and determination of the concentration C of the substance to be investigated with the same method as in individual step 5b) and comparison with the calculated limit of quantification and calculation of the relative error component by applying the error function from method step 6.

**2.** The method according to claim 1, **characterized in that** the error function $F(C)=a*exp(b*C)+d$ is chosen, where C represents the concentration and F(C) the relative error.

3. The method according to one of the preceding claims, **characterized in that** a spectrum of a blank sample which does not contain the substance, or a theoretical noise spectrum or a spectrum of a test sample to be investigated which also contains the sought-after measuring substance is provided as blank spectrum in method step 2., wherein the concentration of the substance in the test sample is already known and the detected signals of the substance are subtracted from the spectrum.

4. The method according to one of the preceding claims, **characterized in that**, when using a plurality of blank samples, the blank spectra are classified in advance, and an error function is determined for each class in order to enable a class-specific processing of new samples.

5. A spectroscopy apparatus designed for automatically carrying out a method according to one of the preceding claims, **characterized in that** the spectroscopy apparatus comprises a measuring unit for recording the measured spectrum of the test sample and/or a measured reference spectrum of the substance to be investigated.

## Revendications

1. Procédé spectroscopique pour déterminer la limite de détermination (= « limit of quantification », LOQ) et pour déterminer l'erreur relative dans la quantification de la concentration d'une substance à analyser dans un échantillon de mesure, la limite de détermination indiquant à quelle concentration de la substance l'erreur relative atteint une valeur prédéfinie $E_B$, et une intensité étant déterminée dans un spectre mesuré en fonction d'une position par une composante de signal qui est imputable à la substance,

comprenant les étapes ou suites d'étapes suivantes :

- 1. sélection d'une fonction d'erreur F(C) qui indique comment l'erreur relative de mesure varie avec la concentration C de la substance et dépend de n paramètres ;
- 2. enregistrement d'un spectre à blanc ;
- 3. acquisition d'un spectre de référence avec la composante de signal de la substance à analyser ;
- 4. détermination d'au moins n concentrations initiales $Ci^0$ (i=1..n) de la substance ;
- 5. exécution des étapes individuelles suivantes pour chaque concentration initiale $Ci^0$ (i=1...n) :

a) multiplication du spectre de référence avec la composante de signal de la substance par un facteur choisi de telle sorte que la composante de signal corresponde à la concentration de la substance ;
b) addition du spectre de l'étape individuelle 5a) au spectre à blanc de l'étape de procédé 2. et détermination de la concentration de la substance $C_i^{step}$ ainsi que détermination de l'erreur relative $E_i^{step}$ associée ;

- 6. adaptation itérative des paramètres de la fonction d'erreur F(C) sélectionnée par les étapes intermédiaires suivantes :

a) détermination des n paramètres de la fonction d'erreur à l'aide de l'erreur relative $E_i^{step}$ déterminée jusqu'ici à l'étape 5b) pour chaque concentration correspondante $C_i^{step}$ ;
b) détermination d'une nouvelle valeur de concentration $C_x$, la fonction d'erreur étant utilisée avec les paramètres déterminés à l'étape intermédiaire 6a) pour déterminer la concentration à la valeur prédéfinie de l'erreur $E_B$ ;
c) exécution des étapes individuelles suivantes pour la concentration $C_x$ déterminée à l'étape 6b) :

i) multiplication du spectre de référence avec la composante de signal de la substance par un facteur choisi de telle sorte que la composante de signal corresponde à la concentration $C_x$ de la substance ;
ii) addition du spectre de l'étape i) au spectre à blanc de l'étape de procédé 2. et détermination de la concentration de la substance $C_x^{step}$ ainsi que détermination de l'erreur relative $E_x^{step}$ ;

d) répétition des étapes intermédiaires 6a) à 6c) avec les valeurs pour la concentration $C_i^{step}$ et l'erreur relative $E_i^{step}$ déterminées à partir des concentrations initiales $C_i^0$ et en outre les valeurs déterminées pour la concentration de la substance $C_x^{step}$ et l'erreur relative $E_x^{step}$ jusqu'à ce que la valeur déterminée de l'erreur relative pour la valeur déterminée de la concentration $C_x^{step}$ se situe dans une plage de tolérance requise de la limite de détermination prédéfinie $E_B$,

- 7. acquisition d'un spectre de mesure de l'échantillon de mesure et détermination de la concentration C de la substance à analyser selon le même procédé qu'à l'étape 5b) et comparaison avec la limite de détermination prédéfinie ainsi que calcul de la composante d'erreur relative par application de la fonction d'erreur de l'étape de procédé 6.

2. Procédé selon la revendication 1, **caractérisé en ce que** F(C)=a*exp(b*C)+d est choisi comme fonction d'erreur, où C représente la concentration et F(C) l'erreur relative.

3. Procédé selon l'une des revendications précédentes, **caractérisé en ce qu'**à l'étape de procédé 2. on enregistre comme spectre à blanc un spectre d'un échantillon à blanc qui ne contient pas la substance, ou qu'à l'étape de procédé 2. on enregistre comme spectre à blanc un spectre de bruit théorique ou un spectre d'un échantillon de mesure à analyser qui contient également la substance de mesure recherchée, la concentration de la substance dans l'échantillon de mesure étant déjà connue et des signaux déterminés de la substance étant retirés du spectre.

4. Procédé selon l'une des revendications précédentes, **caractérisé en ce que**, dans le cas de l'utilisation de plusieurs échantillons à blanc, les spectres à blanc sont classés à l'avance et une fonction d'erreur est déterminée pour chaque classe afin de permettre un traitement spécifique à la classe de nouveaux échantillons.

5. Appareil de spectroscopie conçu pour mettre en œuvre automatiquement un procédé selon l'une des revendications précédentes, **caractérisé en ce que** l'appareil de spectroscopie comprend une unité de mesure pour acquérir le spectre de mesure de l'échantillon de mesure et/ou un spectre de référence mesuré de la substance à analyser.

Fig. 1

Fig. 2a

EP 3 159 681 B1

Fig. 2b

**IN DER BESCHREIBUNG AUFGEFÜHRTE DOKUMENTE**

**In der Beschreibung aufgeführte Patentdokumente**

- DE 102014203721 A1

**In der Beschreibung aufgeführte Nicht-Patentliteratur**

- Method Validation in Pharmaceutical Analysis. Wiley-VCH, 2005

- **MUNECY, H.** MetAssimulo: Simulation of Realistic NMR Metabolic Profiles. *BMC Bioinformatics,* 2010, vol. 11, 496